# EUROPEAN PATENT SPECIFICATION

(11) **EP 0 487 548 B1**
(45) Date of publication and mention of the grant of the patent: **05.03.1997**
(21) Application number: 90911065.2
(22) Date of filing: 09.07.1990
(51) Int. Cl.: H04B 1/16

(54) **SYNTHESIZED SELECTIVE CALL RECEIVER HAVING VARIABLE CHARACTERISTICS**
FUNKRUFEMPFÄNGER MIT SYNTHESIZER MIT VERÄNDERBAREN EIGENSCHAFTEN
RECEPTEUR D'APPEL SELECTIF SYNTHETISE A CARACTERISTIQUES VARIABLES

(30) Priority: 02.08.1989 US 388459
(43) Date of publication of application: 03.06.1992
(73) Proprietor: MOTOROLA, INC., Schaumburg, IL 60196 (US)
(72) Inventor: TAHERNIA, Omid, Coconut Creek, FL 33063 (US); DAVIS, Walter, Lee, Coral Springs, FL 33071 (US); HEROLD, Barry, Wayne, Boca Raton, FL 33432 (US)
(74) Representative: Dunlop, Hugh Christopher
(86) International application number: US9003791
(87) International publication number: WO9102418

(56) References cited:
- US-A- 4 247 952
- US-B- 4 259 740

## Description

### Background of the Invention

This invention relates in general to a selective call receiver having a frequency synthesizer for changing receive frequencies in order to receive a paging signal. This invention more specifically relates to varying characteristics of the receiver in response to the receive frequency.

A paging receiver which receives a paging signal on one of a plurality of receive frequency channels, needs to switch between receive frequency channels. However, the lock time of a frequency synthesizer having a phase lock loop (PLL) may vary depending upon the differences in frequency between two channels. It is desirable to provide a constant lock time when switching channels regardless of the differences in frequency. Furthermore, it is desirable to lock to another channel very rapidly in one instance while the lock time may not be critical in another instance. Thus it is desirable to vary the characteristics of a selective call receiver in order to provide for a desired lock time.

The loop filter of the PLL also effects the noise level of the synthesized frequency used within a superheterodyne receiver, the noise level effects the selectivity of the receiver. Different applications of paging receivers or different channels upon which paging receivers receive paging signals may require differing selectivity performance. Thus it is desirable to adjust the loop bandwidth of a PLL in order to provide a desired level of selectivity performance.

During the reception process, a demodulated signal has a DC component and an AC component upon which the paging signal is included. The DC component is removed in order to digitize the AC component. A complex circuit is used to determine and extract the DC component, such a circuit is shown in U.S. patent 4,631,737 to Davis et al. It is desirable to disable this circuit while the PLL is acquiring lock.

U.S. patent 4,247,952 describes a signal receiving apparatus having a storage device for storing preset channel identity signals representing particular channels to which the apparatus is tuned. Furthermore, the storage device stores preset control signals which are associated with the particular channels identified by the stored preset channel identity signals, which control signals are used to establish desired operating conditions of the signal receiving apparatus for each channel.

### Summary of the Invention

According to a first aspect of the present invention there is provided a selective call receiver comprising decoding means coupled to a synthesizer having a programmable phase lock loop that is arranged to demodulate a received signal of first frequency, the selective call receiver comprising : determining means for determining a difference between the first frequency and an initial frequency of the synthesizer, the determining means generating a difference signal in response thereto; and memory means for storing a plurality of delta bandwidth signals, each corresponding to a respective difference signal, used in selecting among a plurality of selectable characteristics for the selective call receiver; wherein the PLL contains a loop filter having a multiplicity of selectable bandwidths from amongst which one is selectable in response to a particular delta bandwidth signal, and wherein the decoding means is arranged to select one of the delta bandwidth signals stored in the memory means, corresponding to the difference signal generated by the determining means.

In a second aspect of the present invention there is provided a method of controlling a selective call receiver comprising a synthesizer having a programmable phase lock loop that is arranged to demodulate a received signal of first frequency, the phase lock loop including a loop filter, the method comprising the steps of: determining a difference between the first frequency and an initial frequency of the synthesizer and generating a difference signal in response thereto; storing a plurality of variables representing selectable characteristics for the selective call receiver in memory, the variables comprising a plurality of delta bandwidth signals each corresponding to a respective difference signal, and a multiplicity of selectable bandwidths for controlling the sensitivity of the loop filter; selecting one of the plurality of selectable characteristics in response to said generated difference signal such that the selective call receiver demodulates the received signal.

An exemplary embodiment of the present invention will now be described with reference to the accompanying drawings.

### Brief Description of the Drawings

FIG 1 shows a paging receiver operating in accordance with the present invention.

FIG 2 shows a flow chart of a decoder operating in accordance with the present invention.

### Description of a Preferred Embodiment

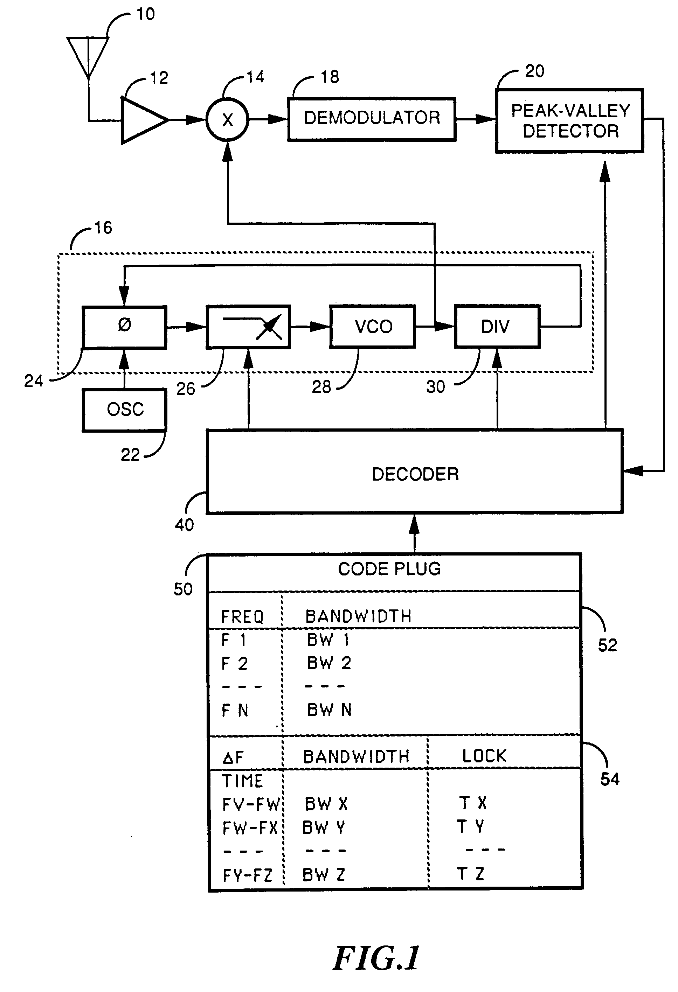

Figure 1 shows a paging receiver operating in accordance with the present invention. RF modulated paging signals are received on antenna 10, amplified by amplifier 12 mixed by mixer 14 with an injection frequency from synthesizer 16 in order to create an intermediate frequency signal. Demodulator 18 generates an audio signal from the intermediate frequency signal. The audio signal is digitized by the peak and valley detector 20 which generates a digital signal from the audio signal. Peak and valley detector 20 is described in U.S. patent 4,631,737 to Davis et al.

Synthesizer 16 comprises a phase lock loop (PLL) and is driven by a reference frequency from oscillator 22. The reference frequency is compared by phase comparator 24. The output of the phase comparator is filtered by a programmable loop filter 26 which is described in U.S. patent US-A-4 901 033 and assigned to the assignee of the present invention which provides for a variable filter characteristic. The output of the loop filter is coupled to voltage controlled oscillator 28 which generates the injection frequency. The injection frequency is further coupled to programmable divider 30 the output of which is coupled to phase comparator 24, thus closing the loop of the PLL.

Decoder 40 receives and processes the digitized signal from peak and valley detector 20 and also enables and disables the peak and valley detector. Programmable filter 26 and programmable divider 30 are also programmed by decoder 40. Decoder 40 includes a microcomputer for performing its functions. Use of a microcomputer or control functions of a paging receiver is known in the art. A preferred microcomputer is the MC68HC05C4 microcomputer manufactured by Motorola Inc. Some elements of the invention described herein are implemented in software operating within the microcomputer.

Codeplug 50 includes several variables used to vary the characteristics of the receiver in response to the receive frequency. A first portion 52 contains frequency information and corresponding loop bandwidth information. A second portion contains the change in frequency information, AF and corresponding bandwidth and lock time information.

For example, if substantial selectivity was required at a first frequency of 131.000 MHz, nominal selectivity was required at a second frequency of 132.000 MHz and selectivity was not critical at 133.000 MHz, table 52 for the paging receiver of this example could read:
F1 = 131.000 MHz BW1 = 50 Hz
F2 = 132.000 MHz BX2 = 75 Hz
F3 = 133.000 MHz BW3 = 120 Hz
The frequencies above indicate receive frequencies, alternately the injection frequency, which differs from the receive frequency by the intermediate frequency, could be used, while maintaining the same bandwidths. Table 52 governs the loop bandwidth while the PLL is locked.

Table 54 governs the loop bandwidth during lock acquisition and table 54 further governs the lock time provided by the decoder. A relationship exists between the loop bandwidth and the lock time. The relationship is characterized and stored in the codeplug for use by the decoder. The following example uses the above frequencies for table 54.

| ΔF | BW | LOCK TIME |
|---|---|---|
| F1-F2 | 330 Hz | 10mS |
| F2-F3 | 330 Hz | 10mS |
| F3-F1 | 660 Hz | 10mS |
| | | |
| F1-F2 | 570 Hz | 5mS |
| F1-F2 | 75 Hz | 25mS |
| | | |
| FS-F1 | 130 HZ | 10mS |
| FS-F2 | 330 Hz | 10mS |
| FS-F3 | 570 Hz | 10mS |

The first three rows show progression from F1 - F3 and back to F1, much like a scanning receiver would operate while scanning channels F1, F2, and F3. The values provide for maintaining a constant lock time independent of the distance in MHz of the frequencies. In order to provide for switching from F1 to F2 or from F2 to F3 with a 10 mS lock time, a 330 Hz bandwidth is used for the loop filter. However, when switching from F3 to F1, a frequency jump twice as far as the prior two, the bandwidth is widened to 660 Hz in order to maintain the constant 10 mS lock time. The fourth and fifth rows show changing the bandwidth in order to provide for faster or slower lock times respectively. These rows may be used in response to commands within the paging signal causing the pager to switch from F1 to F2. The final three rows show starting from a starting frequency FS and bandwidth required to lock on to F1 through F3 respectively in 10 mS. The starting frequency, FS is indicative of the free running frequency of the VCO when it is initially powered on. Thus these rows are used when power is initially applied to the receiver which corresponds to the pager being brought out of the battery saving state.

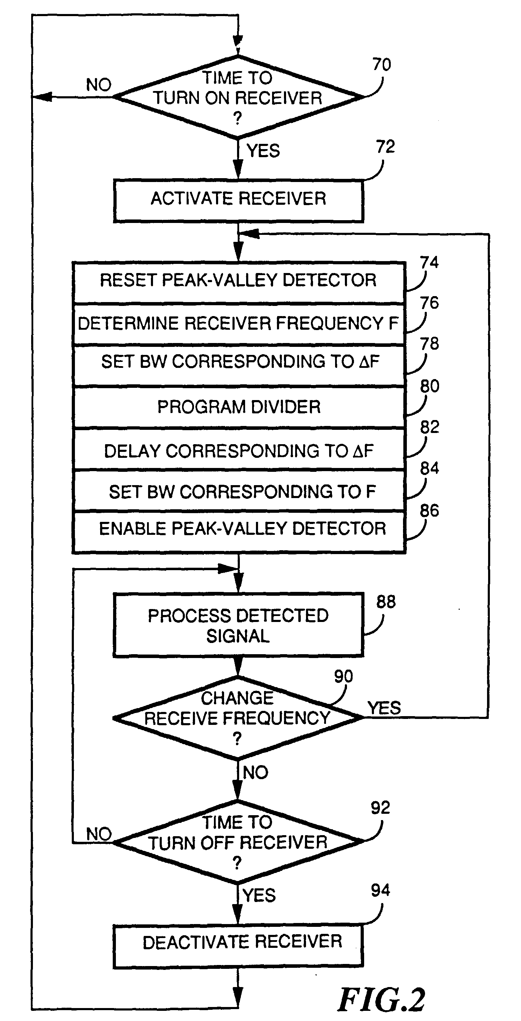

Figure 2 shows a flowchart of a decoder operating in accordance with the present invention. The flowchart begins in step 70 with the receiver in the battery save state, thereby disabled. Step 70 is executed until it is time to turn the receiver on. Then in step 72 the receiver is activated or turned on, thereby exiting the battery saving state. Then in step 74 the peak valley detector is reset. Step 76 determines the receiver frequency which may be made by one of several known algorithms. One such algorithm is shown in U.S. patent 4,644,347 Feb. 17, 1987 to Lucas et al. Step 78 determines the loop bandwidth with which to program loop filter 30. For example say from step 76, the determined frequency was F3, since the VCO was just previously enabled, it is free running thus the decoder selects the bandwidth corresponding to FS-F3 from the table above (570 Hz). The divider 30 is then programmed in order to receive frequency F3. Then a delay is executed by the software as determined by the FS-F3 lock time entry in the codeplug (10mS from the above table). Then in step 84, the bandwidth of the loop filter 26 is changed to correspond to the desired bandwidth of frequency F3 (120 Hz from the table above). After the delay of step 82, the peak and valley detector 20 is enabled.

Thereafter the receiver detects valid digitized information and in step 88 the decoder processes the detected signal. Step 90 checks if the frequency is to be changed, which could be in response to a signal received by the receiver. If the frequency is not to be changed, step 92 checks if it is time to turn off the receiver, a decision which may be made after completing reception of a paging signal. If it is not time to turn the receiver off, step 80 is returned to and signal processing continues. If it is time to turn the receiver off, step 94 deactivates the receiver thereby entering the battery save mode and step 70 is executed.

If in step 90, it was decided it was time to change to a new receive frequency, step 74 would be executed. The peak and valley detector would be reset and the next frequency would be determined. If for example, the pager was in the scanning mode, currently receiving F3, and F1 was the next frequency to be scanned, information from the F3-F1 row of the above table would be used in steps 78-86. If for example, the receiver was receiving F1 and detected a paging signal directing the pager to rapidly switch to F2, the receiver would use the 5mS lock time setting from the F1-F2 row of the table above in steps 78-86.

Note that the programmable loop filter draws higher current when operating in the wider bandwidth, so it is generally desirable to use narrower bandwidths when possible. Furthermore, narrower bandwidths provides for reduced phase noise which may be desirable.

Although the invention has been described by way of example, it should be clear that numerous alternate applications of the principles described herein may be implemented while remaining within the scope of the invention which is defined by the following claims.

## Claims

1. A selective call receiver (10-50) comprising decoding means (40) coupled to a synthesizer (16) having a programmable phase lock loop (22-30) that is arranged to demodulate a received signal of first frequency, the selective call receiver comprising :
determining means for determining a difference between the first frequency and an initial frequency of the synthesizer (16), the determining means generating a difference signal in response thereto; and
memory means (50) for storing a plurality of delta bandwidth signals (52), each corresponding to a respective difference signal, used in selecting among a plurality of selectable characteristics for the selective call receiver;
wherein the PLL (22-30) contains a loop filter (26) having a multiplicity of selectable bandwidths (BW) from amongst which one is selectable in response bandwith signal to a particular delta, and wherein the decoding means (40) is arranged to select one of the delta bandwidth signals (52) stored in the memory means (50), corresponding to the difference signal generated by the determining means.

2. The selective call receiver of claim 1, wherein the memory means (50) further stores at least one lock time delay signal (54), and the selective call receiver further comprises:
delay means (54) for initiating a timed delay in response to the decoding means (40) selecting one of the plurality of selectable characteristics, wherein the timed delay has a time duration corresponding to one of the at least one lock time delay signals associated with the difference signal.

3. The selective call receiver of claim 2, further comprising:
means for generating a completion signal in response to completion of the timed delay, wherein the decoding means (40), in response to the completion signal, selects one of the plurality of selectable characteristics having a bandwidth of the loop filter appropriate to the received signal of first frequency.

4. The selective call receiver of claim 3, wherein the demodulated received signal has DC and AC components, and wherein the selective call receiver further comprises:
means (20) for detecting and removing the DC component and for digitizing the AC component for processing by the decoding means (40), wherein the means (20) for detecting, removing and digitizing is enabled in response to the completion signal.

5. A method of controlling a selective call receiver (10-50) comprising a synthesizer (16) having a programmable phase lock loop (22-30) that is arranged to demodulate a received signal of first frequency, the phase lock loop including a loop filter (26), the method comprising the steps of:
determining a difference between the first frequency and an initial frequency of the synthesizer (16) and generating a difference signal in response thereto;
storing a plurality of variables representing selectable characteristics of the selective call receiver in memory, the variables comprising a plurality of delta bandwidth signals (52) each corresponding to a respective difference signal, and a multiplicity of selectable bandwidths (BW) for controlling the sensitivity of the loop filter (26);
selecting one of the plurality of selectable characteristics in response to said generated difference signal such that the selective call receiver demodulates the received signal.

6. The method according to claim 6, further comprising the steps of:
storing a lock time delay signal associated with the difference signal;
initiating a timed delay having a time duration corresponding to the lock time delay signal;
generating a completion signal in response to completion of the timed delay; and
selecting one of the plurality of selectable characteristics with a bandwidth for the loop filter appropriate to the received signal of first frequency.

7. The method according to claim 5 or 6, wherein the received signal has an AC component, and the method further comprises the steps of:
digitizing the AC component to generate a digital signal, the digital signal comprising the radio frequency modulated information

## Patentansprüche

1. Ein Funkrufempfänger (10-50), der einen Dekodierer (40) umfaßt, der mit einem Synthesizer (16) gekoppelt ist, der einen programmierbaren Phasenregelkreis (22-30) aufweist, der angeordnet ist, ein empfangenes Signal einer ersten Frequenz zu demodulieren, wobei der Funkrufempfänger umfaßt:
eine Bestimmungseinrichtung zum Bestimmen einer Differenz zwischen der ersten Frequenz und einer Anfangsfrequenz des Synthesizers (16), wobei die Bestimmungseinrichtung ein Differenzsignal in Reaktion darauf erzeugt; und
eine Speichereinrichtung (50) zum Speichern einer Mehrzahl von Delta-Bandbreitensignalen (52), von denen jedes einem jeweiligen Differenzsignal entspricht und verwendet wird, unter einer Mehrzahl von auswählbaren Eigenschaften für den Funkrufempfänger auszuwählen;
worin der Phasenregelkreis PLL (22-30) ein Schleifenfilter (26) enthält, das eine Mehrzahl von auswählbaren Bandbreiten (BB) aufweist, unter denen eine in Reaktion auf ein bestimmtes Delta-Bandbreitensignal auswählbar ist, und worin der Dekodierer (40) angeordnet ist, eines der Delta-Bandbreitensignale (52), die in der Speichereinrichtung (50) gespeichert sind, entsprechend dem Differenzsignal auszuwählen, das durch die Bestimmungseinrichtung erzeugt wird.

2. Der Funkrufempfänger des Anspruchs 1, worin die Speichereinrichtung (50) des weiteren mindestens ein Sperrzeitverzögerungssignal (54) speichert, und der Funkrufempfänger des weiteren umfaßt:
eine Verzögerungseinrichtung (54) zum Initiieren einer zeitlich festlegten Verzögerung in Reaktion auf den Dekodierer (40), der eine der Mehrzahl auswählbarer Eigenschaften auswählt, worin die zeitlich festgelegte Verzögerung eine Zeitdauer hat, die einem des wenigstens einen Sperrzeitverzögerungssignal entspricht, das mit dem Differenzsignal verbunden ist.

3. Der Funkrufempfänger des Anspruchs 2, des weiteren umfassend:
eine Einrichtung zum Erzeugen eines Vollendungssignals in Reaktion auf den Abschluß der zeitlich festgelegten Verzögerung, worin der Dekodierer (40) in Reaktion auf das Vollendungssignal eine der Mehrzahl von auswählbaren Eigenschaften auswählt, die eine Bandbreite des Schleifenfilters hat, die für das empfangene Signal der ersten Frequenz geeignet ist.

4. Der Funkrufempfänger des Anspruchs 3, worin das demodulierte, empfangene Signal Gleichstrom- und Wechselstromkomponenten hat, und worin der Funkrufempfänger des weiteren umfaßt:
eine Einrichtung (20) zum Bestimmen und Entfernen der Gleichstromkomponente und zum Digitalisieren der Wechselstromkomponente zur Verarbeitung durch den Dekodierer (40), worin die Einrichtung (20) zum Bestimmen, Entfernen und Digitalisieren in Reaktion auf das Vollendungssignal freigegeben wird.

5. Ein Verfahren zur Steuerung eines Funkrufempfänger (10-50), der Synthesizer (16) umfaßt, der einen programmierbaren Phasenregelkreis (22-30) aufweist, der angeordnet ist, ein empfangenes Signal einer ersten Frequenz zu demodulieren, wobei der Phasenregelkreis ein Schleifenfilter (26) einschließt, wobei das Verfahren die Schritte umfaßt:
Bestimmen einer Differenz zwischen der ersten Frequenz und einer Anfangsfrequenz des Synthesizers (16), und Erzeugen eines Differenzsignals in Reaktion darauf;
Speichern einer Mehrzahl von Variablen in einem Speicher, die auswählbare Eigenschaften des Funkrufempfängers darstellen, wobei die Variablen eine Mehrzahl von Delta-Bandbreitensignalen (52) umfassen, von denen jedes einem jeweiligen Differenzsignal entspricht, und einer Mehrzahl von auswählbaren Bandbreiten (BB) zum Steuern der Empfindlichkeit des Schleifenfilters (26);
Auswählen einer der Mehrzahl von auswählbaren Eigenschaften in Reaktion auf das genannte erzeugte Differenzsignal, so daß der Funkrufempfänger das empfangene Signal demoduliert.

6. Das Verfahren gemäß Anspruch 6, das ferner die Schritte umfaßt:
Speichern eines Sperrzeitverzögerungssignals, das mit dem Differenzsignal verbunden ist;
Initiieren einer zeitlich festgelegten Verzögerung, die eine Zeitdauer hat, die dem Sperrzeitverzögerungssignal entspricht;
Erzeugen eines Vollendungssignals in Reaktion auf den Ab-schluß der zeitlich festgelegten Verzögerung; und
Auswählen einer der Mehrzahl von auswählbaren Eigenschaften mit einer Bandbreite für das Schleifenfilter, die für das empfangene Signal der ersten Frequenz geeignet ist.

7. Das Verfahren gemäß Anspruch 5 oder 6, worin das empfangene Signal eine Wechselstromkomponente hat, und das Verfahren ferner die Schritte umfaßt:
Digitalisieren der Wechselstromkomponente, um ein digitales Signal zu erzeugen, wobei das digitale Signal die HF-modulierten Informationen umfaßt.

## Revendications

1. Récepteur d'appel sélectif (10-50) comprenant un moyen de décodage (40) couplé à un synthétiseur (16) ayant une boucle à phase asservie programmable (22-30) qui est conçue pour démoduler un signal de réception d'une première fréquence, le récepteur d'appel sélectif comprenant :
un moyen de détermination permettant de déterminer une différence entre la première séquence et une fréquence initiale du synthétiseur (16), le moyen de détermination générant un signal de différence en réponse à celui-ci ; et
un moyen formant mémoire (50) permettant de mémoriser une pluralité de signaux à largeur de bande delta (52), chacun correspondant à un signal de différence respectif utilisé lors de la sélection parmi une pluralité de caractéristiques pouvant être choisies pour le récepteur d'appel sélectif ;
dans lequel la PLL (22-30) contient un filtre à boucle (26) ayant une multiplicité de largeurs de bandes pouvant être choisies (BW) parmi lesquelles une peut être choisie en réponse à un signal à largeur de bande delta particulier, et dans lequel le moyen de décodage (40) est conçu pour choisir l'un des signaux à largeur de bande delta (52) mémorisé dans le moyen formant mémoire (50), correspondant au signal de différence généré par le moyen de détermination.

2. Récepteur d'appel sélectif selon la revendication 1, dans lequel le moyen formant mémoire (50) mémorise en outre au moins un signal de retard de temps d'asservissement (54), et dans lequel le récepteur d'appel sélectif comprend en outre :
un moyen de retard (54) permettant d'initialiser un retard en réponse à la sélection par le moyen de décodage (40) d'une caractéristique parmi la pluralité de caractéristiques pouvant être choisies, dans lequel le retard a une durée correspondant à l'un des signaux parmi au moins un des signaux de retard asservi associés au signal de différence.

3. Récepteur d'appel sélectif selon la revendication 2, comprenant en outre :
un moyen permettant de générer un signal d'achèvement en réponse à l'achèvement du retard, dans lequel le moyen de décodage (40), en réponse au signal d'achèvement, choisit une caractéristique parmi la pluralité de caractéristiques pouvant être choisies ayant une largeur de bande du filtre à boucle appropriée au signal reçu d'une première fréquence.

4. Récepteur d'appel sélectif selon la revendication 3, dans lequel le signal reçu démodulé présente des composantes continue et alternative, et dans lequel le récepteur d'appel sélectif comprend en outre :
un moyen (20) permettant de détecter et de retirer la composante continue et de numériser la composante alternative en vue de son traitement par le moyen de décodage (40), dans lequel le moyen (20) permettant de détecter, retirer et numériser est validé en réponse au signal d'achèvement.

5. Procédé de commande d'un récepteur d'appel sélectif (10-50) comprenant un synthétiseur (16) ayant une boucle à phase asservie programmable (22-30) qui est conçue pour démoduler un signal reçu d'une première fréquence, la boucle à phase asservie comportant un filtre à boucle (26), le procédé comprenant les étapes de :
détermination d'une différence entre la première fréquence et une fréquence initiale du synthétiseur (16) et génération d'un signal de différence en réponse à celle-ci ;
mémorisation d'une pluralité de variables représentant des caractéristiques pouvant être choisies du récepteur d'appel sélectif dans la mémoire, les variables comprenant une pluralité de signaux à largeur de bande delta (52) chacun correspondant à un signal de différence respectif, et une multiplicité de largeurs de bandes pouvant être choisies (BW) permettant de commander la sensibilité du filtre à boucle (26) ;
sélection de l'une des caractéristiques parmi la pluralité de caractéristiques pouvant être choisies en réponse audit signal de différence généré de telle sorte que le récepteur d'appel sélectif démodule le signal reçu.

6. Procédé selon la revendication 6, comprenant en outre les étapes de :
mémorisation d'un signal de retard d'asservissement associé au signal de différence ;
initialisation d'un retard ayant une durée correspondant au signal de retard d'asservissement ;
génération d'un signal d'achèvement en réponse à l'achèvement du retard ; et
sélection de l'une des caractéristiques parmi la pluralité de caractéristiques pouvant être choisies ayant une largeur de bande pour le filtre à boucle appropriée au signal reçu d'une première fréquence.

7. Procédé selon la revendication 5 ou 6, dans lequel le signal reçu présente une composante alternative, et le procédé comprend en outre les étapes de :
numérisation de la composante alternative de façon à générer un signal numérique, le signal numérique comprenant les informations modulées radiofréquence.
